# EUROPÄISCHE PATENTSCHRIFT

(11) **EP 1 444 876 B1**
(45) Veröffentlichungstag und Bekanntmachung des Hinweises auf die Patenterteilung: **03.08.2005**
(21) Anmeldenummer: 02792595.7
(22) Anmeldetag: 12.11.2002
(51) Int. Cl.: H05K 13/04

(54) **VORRICHTUNG UND VERFAHREN ZUM BESTÜCKEN VON SUBSTRATEN MIT ELEKTRISCHEN BAUELEMENTEN MITTELS IN ZWEI PARALLELEN FÜHRUNGSBAHNEN VERSCHIEBBARER BESTÜCKKÖPFE**
DEVICE AND METHOD FOR EQUIPPING SUBSTRATES WITH ELECTRICAL COMPONENTS BY MEANS OF INSERTION HEADS WHICH CAN BE DISPLACED IN TWO PARALLEL GUIDE TRACKS
DISPOSITIF ET PROCEDE PERMETTANT D'EQUIPER DES SUBSTRATS AVEC DES COMPOSANTS ELECTRIQUES AU MOYEN DE TETES D'INSERTION POUVANT ETRE DEPLACEES DANS DEUX GLISSIERES DE GUIDAGE PARALLELES

(30) Priorität: 16.11.2001 DE 10156266
(43) Veröffentlichungstag der Anmeldung: 11.08.2004
(73) Patentinhaber: SIEMENS AKTIENGESELLSCHAFT, 80333 München (DE)
(72) Erfinder: MEHDIANPOUR, Mohammad, 81829 München (DE); AIGNER, Sebastian, 82393 Iffeldorf (DE)
(86) Internationale Anmeldenummer: PCT/DE2002/004184
(87) Internationale Veröffentlichungsnummer: WO 2003/047327

(56) Entgegenhaltungen:
- EP-A- 0 779 777
- WO-A-00/71306

## Beschreibung

Die Erfindung bezieht sich auf eine Vorrichtung und ein Verfahren zum Bestücken von Substraten mit elektrischen Bauelementen mittels zumindest zwei Bestückköpfen, die in zwei stationären, zueinander zumindest abschnittsweise parallelen, benachbarten, definiert verlaufenden Führungsbahnen der Vorrichtung verschiebbar sind, wobei die unabhängig voneinander verschiebbaren Bestückköpfe mit Greifern zum Halten der Bauelemente versehen sind, wobei die Bestückköpfe mit ihren Greifern über zumindest einer zu den Führungsbahnen parallelen Reihe von Abholstellen der Bauelemente verschiebbar sind und wobei sich die Führungsbahnen über zumindest einen quer zu den Führungsbahnen verschiebbaren Substratträger erstrecken.

Eine solche Vorrichtung ist zum Beispiel durch die EP 1117287A1 bekannt geworden. Darin ist in Figur 59 eine Bestückvorrichtung mit zwei benachbarten zueinander parallelen stationären Führungsschienen bekannt geworden, an denen je zwei Bestückköpfe zur Handhabung der elektrischen Bauelemente verschiebbar gelagert sind. Die Führungsschienen erstrecken sich über Abholstellen von Zuführeinrichtungen für die Bauelemente sowie über quer verschiebbare Substratträger. Die Zuführeinrichtungen sind entsprechend dem Abstand der Führungsschienen zueinander versetzt angeordnet. Im Bereich der Bestückköpfe sind ferner an jeder Führungsschiene zwischen den Zuführeinrichtungen und den Substratträgern jeweils eine Bauteilekamera zur optischen Vermessung der Lage der Bauteile an den Bestückköpfen auf den einander abgewandten Seiten der Führungsschienen angeordnet. Die Positionen der Substratträger und der Bestückköpfe können derart miteinander kombiniert werden, dass Bauteile auf den vorbestimmten Positionen des Substrats aufgesetzt werden können. Ist das Substrat in der Verschieberichtung des Substratträgers länger als der Abstand zwischen den Bestückköpfen der beiden Führungsschienen, so ist es möglich, mit beiden Führungsschienen gleichzeitig zu bestücken, solange beide Bestückspuren das Substrat überdecken. Während einer Anfangs- und einer Endphase wird das Substrat lediglich von einer der beiden Führungsschienen überdeckt, so dass in dieser Zeit nur an einer der Führungsschienen bestückt werden kann.

Der Erfindung liegt die Aufgabe zugrunde, die Bestückleistung der Vorrichtung zu steigern sowie die Positioniergenauigkeit zu erhöhen.

Diese Aufgabe wird durch die Erfindung gemäß Anspruch 1 gelöst. Die zum Beispiel an einem gemeinsamen Körper ausgebildeten Führungsbahnen können zueinander einen solch engen Abstand aufweisen, dass die Bestückköpfe mit geringem seitlichen Spiel kollisionsfrei aneinander vorbeigleiten können. Dadurch, dass die z. B. als Saugpipetten ausgebildeten Greifer an den einander zugewandten Seiten angeordnet sind, wird der Abstand zwischen den Bewegungsbahnen der Greifer noch weiter reduziert. Durch eine spiegelbildliche Anordnung der Bestückköpfe wird die Annäherung der Greifer mit einem einzigen Kopftyp ermöglicht. Dadurch werden die Einlauf- und die Auslaufstrecke des Substrats so kurz, dass dieses nahezu über die gesamte Länge von beiden Führungsbahnen überdeckt wird, so dass dabei das Substrat in enger zeitlicher Verzahnung an beiden Greiferbahnen bestückt werden kann. Das heißt, dabei ist es vorteilhaft, die Reihenfolge der Bauelemente so zu wählen, dass das Substrat in kleinen Schritten stets in eine Richtung bewegt werden kann. Wenn nun gerade ein Bauteil mit einem Bestückkopf aufgesetzt wird, kann der Bestückkopf der anderen Führungsbahn bereits in die vorgesehen Aufsetzposition verfahren und nach einer kurzen Vorschubbewegung des Substrats das nächste Bauteil auf das Substrat aufsetzen. Dadurch werden zwischen zwei Bestückvorgängen große Verschiebewege vermieden, so dass sich der zeitliche Abstand zwischen zwei Bestückvorgängen entsprechend verringert. Besonders vorteilhaft ist es, wenn sich die Führungsbahnen über zwei benachbarte parallel verschiebbare Substratträger erstrecken und ein Bestückkopf einer Führungsbahn über einem Substrat und ein Bestückkopf der anderen Führungsbahn über dem anderen Substrat positioniert ist. Dann können beide Bestückköpfe, ohne aufeinander achten zu müssen, gleichzeitig Bauteile mit voller Leistung auf die Substrate aufsetzen.

Die Zuführeinrichtungen für die Bauelemente können wechselweise so gestaffelt sein, dass sich ihre Abholstellen auf beide Greiferbahnen verteilen. Entsprechend dem engen Abstand der Greifer beider Greiferbahnen ist der Abstand zwischen den beiden Abholspuren so gering, dass die zugehörigen Zuführeinrichtungen auf einem gemeinsamen Träger in gleicher Orientierung befestigt werden können. Dadurch können die Zuführeinrichtungen für beide Spuren die gleiche Bedienrichtung aufweisen.

Vorteilhafte Weiterbildungen der Erfindung sind in den Unteransprüchen gekennzeichnet.

Durch die Weiterbildung nach Anspruch 2 wird der Abstand zwischen den Greifern der beiden Bestückköpfe und damit die Länge der Einlauf- und Auslaufstrecke auf ein Minimum verringert.

Durch die Weiterbildung nach Anspruch 3 können die Zuführeinrichtungen auf einem gemeinsamen Träger befestigt werden. Die gleiche Orientierung ermöglicht die Bedienung der Zuführeinrichtungen aus einer Richtung z. B. für den Fall, dass ein Vorratsmagazin für die Bauelemente ausgewechselt werden muss.

Die Umlaufstrecke nach Anspruch 4 ermöglicht einen kontinuierlichen Umlaufbetrieb an jeder der beiden Strecken unabhängig voneinander. Dabei ist es möglich, die Umlaufstrecke über zusätzliche Abholstellen und Bestückfelder zu führen und so die Leistung der Vorrichtung entsprechend zu erhöhen.

Die Weiterbildung nach Anspruch 5 ergibt einen einfachen Aufbau der Vorrichtung. Die Linearführungen ermöglichen einen reibungsarmen präzisen Betrieb der Bestückköpfe.

Durch die Weiterbildung nach Anspruch 6 ist es möglich, mit beiden Bestückköpfen auf sämtliche Abholstellen zuzugreifen, wobei durch die Weiterbildung nach Anspruch 7 die Querverschiebung halbiert wird.

Durch die Weiterbildung nach Anspruch 8 ermöglicht die Verwendung von Bestückköpfen mit unverschiebbaren Greifern. Durch die Verschiebbarkeit der Abholstellen können ebenfalls beide Bestückköpfe auf sämtliche Abholstellen zugreifen. Bei der Verwendung von Bestückköpfen mit einer Vielzahl von einer linear angeordneten Greifern ist es sinnvoll, diese abwechselnd in den Abholbereich zu führen, so dass die Zuführeinrichtungen erst nach einer größeren Anzahl von aufgenommenen Bauelementen gemeinsam verschoben werden müssen.

Durch die Weiterbildung nach Anspruch 9 ist es möglich, weder die Abholstellen, noch die Greifer quer zur Linearführung verschieben zu müssen.

Dies trifft ebenfalls auf die Anordnung der Abholstellen nach Anspruch 10 zu, wobei jeder die einzelnen Bestückköpfe nur auf die in ihrer Spur gelegenen Bauelemente zugreifen zu kann.

Die Weiterbildung nach Anspruch 11 ermöglicht es, den Abstand zwischen den einzelnen Abholstellen einer Reihe zu verdoppeln und damit den Abstand der Greifer in den Bestückköpfen anzupassen. Damit ist es möglich, mehrere Bauelemente in enger zeitlicher Folge mit geringen Verschiebebewegungen des Bestückkopfes abzuholen.

Die Zusammenfassung der Abholstellen nach Anspruch 12 macht es zum Beispiel möglich, die häufiger benötigten Bauelemente mit kürzeren Transportwegen auf der dem Substrat zugewandten Seite anzuordnen.

Bei der Weiterbildung nach Anspruch 13 wird ein besonderer Vorteil der Erfindung evident. Der geringe Abstand zwischen den Greifern der beiden Bestückköpfe macht es möglich, für beide Seiten eine gemeinsame stationäre Kamera zu nutzen, wodurch sich der entsprechende Aufwand für die Lageerfassung der Bauelemente halbiert.

Der gemeinsame Träger für die Führungsbahnen nach Anspruch 14 begünstigt ihre genaue parallele Ausrichtung zueinander.

Durch die Weiterbildung nach Anspruch 15 lassen sich die Montageflächen für die Führungsbahnen in einem Arbeitsgang mit hoher Genauigkeit erzeugen.

Durch die Weiterbildung nach Anspruch 16 kann die Anzahl der Abholstellen und damit die Anzahl der bereitgestellten Bauelemente vergrößert werden.

Die Bestückköpfe nach Anspruch 17 können wechselweise Bauteile bestücken und abholen, was ein weitgehend unterbrechungsfreies Arbeiten ermöglicht.

Durch die Weiterbildung nach Anspruch 18 wird eine entsprechende Vielzahl von Bauelementen am Bestückkopf gespeichert und anschließend in einem kontinuierlichen Bestückgang auf das Substrat aufsetzt.

Durch die Vorrichtung nach Anspruch 19 wird der enge Abstand der beiden Greiferreihen für den Bestückkopf dem Teilungsabstand zwischen den Greifern eines Bestückkopfs angeglichen, was das Positioniermanagement erleichtert.

Die Weiterbildung nach Anspruch 20 ermöglicht eine schnelle und präzise Positionierung der Bestückköpfe in der Linearführung.

Bei der Weiterbildung nach Anspruch 21 sind die Zuführeinrichtungen senkrecht zur Transportstrecke orientiert und leicht zugänglich. Bei einer Erweiterung der Zuführeinrichtungen um zusätzliche Bauelemente wird zwar die Bestückvorrichtung in der Transportrichtung verlängert, jedoch bleibt ihre Breite unverändert, so dass sich auch eine solche Maschine problemlos in eine Bestücklinie einfügen lässt.

Durch die Weiterbildung nach Anspruch 22 ist es möglich, einen Substratwechsel während des Bestückens des anderen Substrates vorzunehmen, so dass auch dann die volle Bestückleistung erreicht werden kann.

Durch die Weiterbildung nach Anspruch 23 kann die Anzahl der bereitgestellten Bauelemente und die Bestückleistung verdoppelt werden.

Durch die Weiterbildung nach Anspruch 24 ist es möglich, gleichzeitig mit zwei Bestückköpfen auf ein Substrat zuzugreifen und die Bestückleistung entsprechend zu erhöhen.

Das Verfahren nach Anspruch 25 führt zu einer maximalen Auslastung der Bestückvorrichtung.

Im folgenden wird die Erfindung anhand von in der Zeichnung dargestellten Ausführungsbeispiel näher erläutert. Es zeigen:
- Figur 1: schematisiert eine Seitenansicht einer Bestückvorrichtung nach der Erfindung;
- Figur 2: eine Stirnansicht der Vorrichtung nach Anspruch 1;
- Figur 3: eine Draufsicht auf die Vorrichtung nach Figur 1 ohne ein oberes Chassisteil;
- Figur 4: eine Teilansicht der Vorrichtung nach Figur 2;
- Figuren 5 bis 7,: Varianten von Teilen der Vorrichtung nach Figur 4;
- Figur 8: eine Seitenansicht einer anderen Vorrichtung nach der Erfindung;
- Figur 9: eine Draufsicht auf die Vorrichtung nach Figur 8.

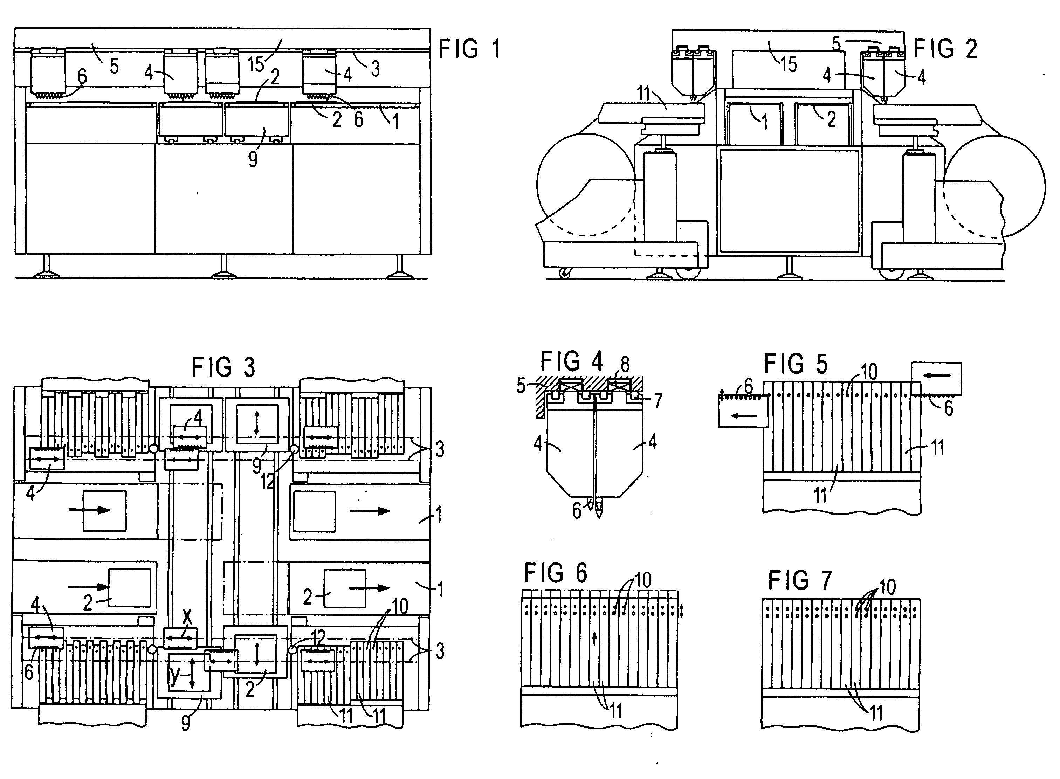

Nach den Figuren 1 bis 4 sind zu beiden Seiten einer doppelspurigen Transportstrecke 1 für Substrate 2 lineare Führungsbahnen 3 für Bestückköpfe 4 angeordnet und erstrecken sich parallel zur Transportstrecke 1 in einer X-Richtung über die gesamte Länge der Bestückvorrichtung. Auf jeder Seite sind zwei zueinander parallele, eng benachbarte Führungsbahnen angeordnet, die auf der Unterseite eines stationären Trägers 5 ausgebildet sind, der an einem oberen Chassisteil 15 ausgebildet ist. In jeder der Führungsbahnen 3 sind zwei der Bestückköpfe 4 längs verschiebbar geführt. Die Bestückköpfe 4 sind mit einer Reihe von als Saugpipetten Greifern 6 versehen, die entlang einer in der X-Richtung entsprechenden Längsseite des Bestückkopfes 4 angeordnet sind. Nach Figur 4 sind die Bestückköpfe 4 und ein Teil des Trägers 5 vergrößert dargestellt. Die in den beiden benachbarten Führungsbahnen 3 verschiebbaren Bestückköpfe 4 sind spiegelbildlich derart angeordnet, dass ihre Greifer 6 auf den einander zugewandten Längsseiten liegen. Der freie Seitenabstand zwischen diesen Bestückköpfen ist so gering, dass die gerade noch kollisionsfrei aneinander vorbeifahren können. Die Greiferreihen 6 sind so weit wie möglich zu den Längsseiten hin verlagert, so dass sich zwischen den Greiferreihen der beiden Bestückköpfe 4 ein geringer Seitenabstand ergibt. Die Führungsbahnen 3 sind durch zueinander passende Führungselemente 7 des Trägers 5 und der Bestückköpfe 4 gebildet. Zwischen den Führungselementen 7 sind im Träger 5 Magnetreihen und in den Bestückköpfen Spulenteile angeordnet, die zusammen Linearmotoren 8 zum Betreiben der Bestückköpfe 4 bilden.

Im zentralen Bereich der Bestückvorrichtung ist die Transportstrecke 1 durch quer zu dieser in einer Y-Richtung verschiebbare Substratträger 9 unterbrochen. Diese übernehmen die Substrate von einer Zuführseite der Transportstrecke 1 und transportieren sie quer zu dieser bis in den Verfahrbereich der Bestückköpfe 4. Zu beiden Seiten der Substratträger 9 sind unter den Bestückköpfen 4 Abholstellen 10 von Zuführeinrichtungen 11 für zu bestückende Bauelemente in der X-Richtung aneinander gereiht und je zur Hälfte auf die beiden Verschiebestrecken der Greifer 6 verteilt, indem die Zuführeinrichtungen entsprechend versetzt angeordnet sind. Dieser Versatz kann von Zuführeinrichtung zu Zuführeinrichtung alternierend oder auch blockweise realisiert sein. Zwischen den Abholstellen 10 und den Substratträgern 9 ist jeweils eine für beide Greiferstrecken gemeinsame, als Digitalkamera ausgebildete Abtastoptik 12 angeordnet, die die Bauelemente beider Greiferreihen erfassen und in ihrer Lage vermessen kann.

Die Substratträger 9 sind senkrecht zur Verfahrrichtung X der Bestückköpfe 4 in Querführungen 13 in einer zweiten Koordinatenrichtung y verschiebbar. Sie werden zunächst aus der Transportstrecke 1 heraus soweit verschoben, bis die innere Kante des jeweiligen Substrats 2 die äußere Greiferbahn erreicht. Im Bereich der Bestückköpfe kann der Substratträger 9 in seiner Verschieberichtung y exakt positioniert werden. Die Position der Bauelemente auf dem Substrat 2 kann nun durch eine Kombination der X-Koordinaten des Bestückkopfes 4 und der Y-Koordinaten des Substratträgers 9 eingestellt werden. Es ist dabei von Vorteil, die Abfolge der Bauelemente so zu wählen, dass das Substrat 2 zeilenweise bestückt werden kann, um seine Verschiebewege kurz zu halten. Die Abholstellen 10 der Zuführeinrichtungen sind zueinander so versetzt, dass sie genau unter den beiden Greiferbahnen liegen, so dass sich der Bauteilevorrat auf die beiden Bestückstrecken verteilt.

Nach Figur 5 sind die Abholstellen 10 der Zuführeinrichtungen 11 in einer Linie aneinander gereiht, die Greifer 6 der abgewandten Bestückköpfe 4a sind in diesen quer zur X-Richtung um ihren halben Reihenabstand verschiebbar, wie dies am rechten der beiden Bestückköpfe 4a gezeigt ist.

Dadurch können sämtliche Bestückköpfe 4a einer Doppelspur auf sämtliche Abholstellen 10 und damit auf den gesamten Bauteilevorrat zugreifen.

Unmittelbar danach werden die Greifer 6 in den Bestückkopf 4a zurückgezogen, wie dies am linken der beiden Bestückköpfe 4a dargestellt ist. Dadurch können die Bestückköpfe beider Spuren mit Ausnahme der Abholphase kollisionsfrei aneinander vorbeifahren.

Nach Figur 6 sind die Abholstellen 10 der Zuführeinrichtungen 11 ebenfalls in einer Linie aneinander gereiht. Die Zuführmodule sind jedoch in ihrer Gesamtheit um den Reihenabstand der Greifer quer zu deren Verfahrrichtung verschiebbar, wie dies durch die strichpunktierten Linien angedeutet ist. Dabei ist es von Vorteil, die beiden Bestückköpfe der beiden Führungsbahnen alternierend abholen zu lassen und der Zuführeinrichtungen 11 in die Wechselphase zu legen. Erreicht werden kann dies, indem die Zuführeinrichtungen 11 eines Zuführblocks auf einem gemeinsamen Tisch befestigt sind, der mit einem Verschiebeantrieb gekoppelt ist.

Abgewandte Zuführeinrichtungen 11a nach Figur 7 weisen jeweils zwei der Abholstellen auf, die zusammen eine Doppelreihe im Abstand der beiden Greiferreihen bilden. Dadurch können die Greifer sämtlicher Bestückköpfe ohne Verschiebung der Greifer bzw. der Zuführeinrichtungen auf sämtliche Bauelemente zugreifen.

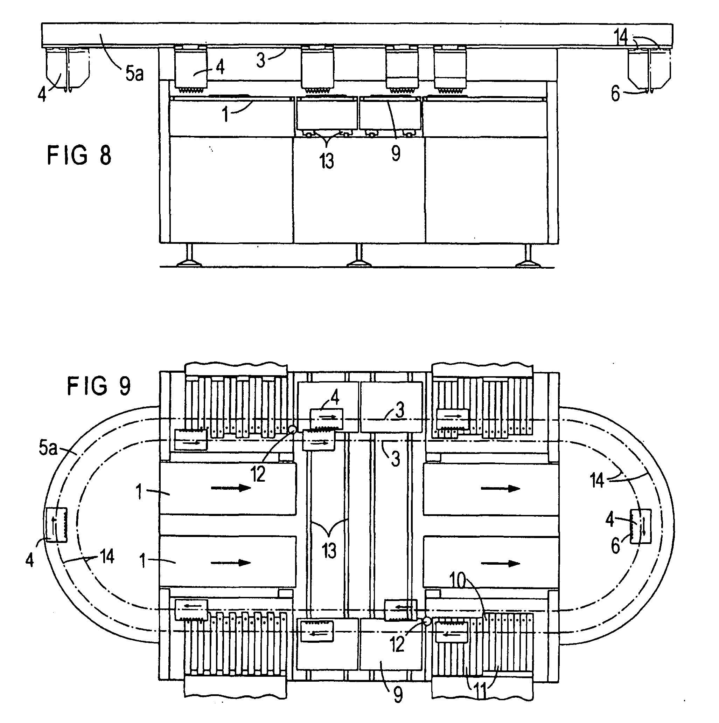

Die Figuren 8 und 9 zeigen eine abgewandelte Zuführeinrichtung im Vergleich mit der Vorrichtung nach den Figuren 1 bis 3 weitgehend übereinstimmende Teile aufweist. Der wesentliche Unterschied besteht darin, dass hier die beiden Führungsbahnpaare 3 zu beiden Seiten der Transportstrecke 1 über bogenförmige Verbindungsstrecken 14 zu zwei geschlossenen Umlaufstrecken verbunden sind, in denen die Bestückköpfe 4 mit ihren Greifern 6 in zwei eng benachbarten Spuren über den Abholstellen 10 und den Substratträgern 9 umlaufend verfahrbar sind. Durch eine Erhöhung der Anzahl der Bestückköpfe ist es möglich, in beiden Spuren kontinuierlich abzuholen und zu bestücken, wodurch die Bestückleistung noch weiter gesteigert werden kann.

Es ist vorteilhaft, die Bestückköpfe 4 in beiden Spuren in gleicher Richtung umlaufen zu lassen, so dass sie stets von einer Seite her in den Bestückbereich hineinfahren. Dadurch wird auf beiden Seiten der Transportstrecke 1 nur je eine Abtastoptik 12 benötigt. Der Träger 5a ist über die Stirnseiten der Bestückvorrichtung hinaus so weit verlängert, dass an seiner Unterseite die bogenförmigen Verbindungsstrecken 14 angebracht werden können.

### Bezugszeichenliste

- 1: Transportstrecke
- 2: Substrat
- 3: Führungsbahn
- 4, 4a: Bestückkopf
- 5, 5a: Träger
- 6: Greifer
- 7: Führungselement
- 8: Linearmotor
- 9: Substratträger
- 10: Abholstelle
- 11, 11a: Zuführeinrichtung
- 12: Abtastoptik
- 13: Querführung
- 14: Verbindungsstrecke
- 15: Chassisteil

## Patentansprüche

1. Vorrichtung zum Bestücken von Substraten (2) mit elektrischen Bauelementen mittels zumindest zwei Bestückköpfen (4), die in zwei stationären, zueinander zumindest abschnittsweise parallelen, benachbarten, definiert verlaufenden Führungsbahnen (3) der Vorrichtung verschiebbar sind,
wobei die unabhängig voneinander verschiebbaren Bestückköpfe (4) mit Greifern (6) zum Halten der Bauelemente versehen sind,
wobei die Bestückköpfe (4) mit ihren Greifern (6) über zumindest einer zu den Führungsbahnen (3) parallelen Reihe von Abholstellen (10) der Bauelemente verschiebbar sind und
wobei sich die Führungsbahnen (3) über zumindest einen quer zu den Führungsbahnen (3) verschiebbaren Substratträger (9) erstrecken,
**dadurch gekennzeichnet, dass** die Bestückköpfe (4) in den beiden Führungsbahnen (3) mit einem derart geringem freien Seitenabstand geführt sind,
dass die Bestückköpfe nach kollisionsfrei aneinander vorbeigleiten, und
dass die Greifer (6) im Bereich der einander zugewandten Seiten der beiden Bestückköpfe angeordnet sind.

2. Vorrichtung nach Anspruch 1,
**dadurch gekennzeichnet, dass** die Greifer (6) in den einander zugewandten unmittelbaren Randbereichen der Bestückköpfe (4)angeordnet sind und dass der Seitenabstand zwischen den Bestückköpfen auf einen schmalen Sicherheitsspalt reduziert ist.

3. Vorrichtung nach Anspruch 1 oder 2,
**dadurch gekennzeichnet, dass** die Abholstellen aufweisende Zuführeinrichtungen (11) für die Bestückköpfe (4) beider Führungsbahnen in der gleichen Richtung orientiert sind.

4. Vorrichtung nach Anspruch 1, 2 oder 3,
**dadurch gekennzeichnet, dass** die Führungsbahnen (3) Teile einer zweispurigen geschlossenen Umlaufstrecke für die Bestückköpfe (4) sind.

5. Vorrichtung nach Anspruch 1, 2 oder 3,
**dadurch gekennzeichnet, dass** die Führungsbahnen (3) als durchgehende Linearführungen ausgebildet sind, in denen die Bestückköpfe (4) über den Abholstellen (10) und dem Substratträger (9) hin und her verschiebbar sind.

6. Vorrichtung nach einem der Ansprüche 1 bis 5,
**dadurch gekennzeichnet, dass** die Abholstellen (10) in einer Reihe angeordnet sind und
dass die Greifer (6) zumindest eines der Bestückköpfe (4) quer zur Linearführung bis über die Abholstellen (10) verschiebbar sind.

7. Vorrichtung nach Anspruch 6,
**dadurch gekennzeichnet, dass** die Abholstellen (10) in einer zwischen den Verschiebestrecken der Bestückköpfe (4) gelegenen Reihe angeordnet sind und
dass die Greifer (6) beider Bestückköpfe (6a) bis über die Abholstellen (10) verschiebbar sind.

8. Vorrichtung nach einem der Ansprüche 1 bis 5,
**dadurch gekennzeichnet,**
**dass** die Abholstellen (10) aufweisende Zuführeinrichtungen (11) quer zu den Linearführungen derart verschiebbar sind, dass die Abholstellen (10) wechselweise unter die Verschiebestrecken der Greifer (6) der beiden Bestückköpfe (4) gelangen.

9. Vorrichtung nach einem der Ansprüche 1 bis 5,
**dadurch gekennzeichnet, dass** die Zuführeinrichtungen (11a) zwei Reihen von Abholstellen (10) im Abstand der beiden Verschiebestrecken der Greifer (6) aufweisen.

10. Vorrichtung nach einem der Ansprüche 1 bis 5,
**dadurch gekennzeichnet, dass** die Abholstellen (10) auf beide Verschiebestrecken der Greifer (6) verteilt sind.

11. Vorrichtung nach Anspruch 10,
**dadurch gekennzeichnet, dass** die jeweils einem Abholbereich zugeordneten Abholstellen (10) in alternierender Reihung auf die beiden Greiferstrecken verteilt sind.

12. Vorrichtung nach Anspruch 10,
**dadurch gekennzeichnet, dass** die jeweils einem Abholbereich zugeordneten Abholstellen (10) blockweise zusammengefasst sind.

13. Vorrichtung nach einem der vorhergehenden Ansprüche,
**dadurch gekennzeichnet, dass** unter den beiden Verschiebestrecken der Greifer (6) eine Abtastoptik (12) angeordnet ist, die die Greifer (6) beider Bestückköpfe (4) überdeckt.

14. Vorrichtung nach einem der vorhergehenden Ansprüche,
**dadurch gekennzeichnet, dass** die getrennten Führungsbahnen (3) für die beiden Bestückköpfe (4) an einem gemeinsamen stationären Träger (5) der Vorrichtung angeordnet sind.

15. Vorrichtung nach Anspruch 14,
**dadurch gekennzeichnet, dass** die Führungsbahnen (3) bildende Führungselemente (7) für die Bestückköpfe (4) auf der Unterseite des Trägers (5) an einer gemeinsamen Montagebasis angebracht sind.

16. Vorrichtung nach einem der vorhergehenden Ansprüche,
**dadurch gekennzeichnet, dass** die Abholstellen (10) zu beiden Seiten des Substratträgers (9) angeordnet sind.

17. Vorrichtung nach Anspruch 16,
**dadurch gekennzeichnet, dass** in zumindest einer der beiden Führungsbahnen (3) mehrere der Bestückköpfe (4) unabhängig voneinander verschiebbar sind.

18. Vorrichtung nach einem der vorhergehenden Ansprüche ,
**dadurch gekennzeichnet, dass** der Bestückkopf (4) mehrere der in der Verschieberichtung aneinandergereihten Greifer (6) aufweist.

19. Vorrichtung nach Anspruch 18,
**dadurch gekennzeichnet, dass** der Seitenabstand zwischen den beiden Reihen der Greifer (6) beider Bestückköpfe (4) gleich dem Abstand zwischen zwei in der Verschieberichtung aneinander gereihten Greifern (6) eines der Bestückköpfe (4) ist.

20. Vorrichtung nach einem der vorhergehenden Ansprüche ,
**dadurch gekennzeichnet, dass** den beiden Führungsbahnen (3) stationäre Antriebselemente eines Linearmotors (8) zugeordnet sind und dass die Bestückköpfe(4) mit beweglichen Antriebselementen des Linearmotors (8) versehen sind.

21. Vorrichtung nach einem der vorhergehenden Ansprüche ,
**dadurch gekennzeichnet, dass** eine Transportstrecke (1) für die Substrate parallel zu den Führungsbahnen (3) verläuft und
dass der Substratträger (9) quer zur Transportstrecke (1) aus dieser heraus bis unter die Führungsbahnen (3) der Bestückköpfe (4) schiebbar ist.

22. Vorrichtung nach Anspruch 21,
**dadurch gekennzeichnet, dass** zwei der Substratträger (9) nebeneinander aus der Transportstrecke (1) heraus schiebbar sind.

23. Vorrichtung nach einem der vorhergehenden Ansprüche ,
**dadurch gekennzeichnet, dass** auf der den Führungsbahnen (3) gegenüberliegenden Seite der Transportstrecke (1) weitere Führungsbahnen (3), Abholstellen (10) für die Bauelemente und Substratträger (9) vorgesehen sind.

24. Vorrichtung nach einem der vorhergehenden Ansprüche ,
**dadurch gekennzeichnet, dass** die beiden Bestückköpfe (4) gleichzeitig in je eine Bestückposition und/oder in je eine Abholposition verfahrbar sind.

25. Verfahren zum Bestücken von Substraten (2) mit elektrischen Bauelementen mittels zumindest zweier Bestückköpfe (4),
die in zwei stationären, zueinander zumindest abschnittsweise parallelen, benachbarten, definiert verlaufenden Führungsbahnen (3)der Vorrichtung unabhängig voneinander verschoben werden,
wobei die Bestückköpfe (4) mit Greifern (6) zum Halten der Bauelemente über zumindest einer zu den Führungsbahnen (3) parallelen Reihe von Abholstellen (10) der Bauelemente und über einen quer zu den Führungsbahnen (3) bewegbaren Substratträger (9)verschoben werden insbesondere nach einem der vorhergehenden Ansprüche,
**dadurch gekennzeichnet, dass** die Bestückköpfe (4) der beiden Führungsbahnen (3) mit derart engem Seitenabstand dass die Bestückköpfe (4) nach Kollisionsfrei aneinander vorbeigleiten, geführt werden,
dass die Greifer (6) der beiden Bestückköpfe (4) an den einander zugewandten Seiten angeordnet sind und
dass die Bestückköpfe (4) gleichzeitig in je eine Bestückposition und/oder in je eine Abholposition verfahren werden.

## Claims

1. Device for equipping substrates (2) with electrical components by means of at least two insertion heads (4) which can be displaced in two stationary guide tracks (3) of the device, said guide tracks being parallel at least in sections, adjacent and running in a defined manner,
wherein the insertion heads (4) which can be displaced independently of one another are furnished with grips (6) for holding the components,
wherein the insertion heads (4) with their grips (6) can be displaced over at least one row of component pickup positions (10), said row being parallel to the guide tracks (3), and
wherein the guide tracks (3) extend over at least one substrate carrier (9) which can be displaced transversely in relation to the guide tracks (3),
**characterised in that** the insertion heads (4) are guided in the two guide tracks (3) with such limited lateral displacement that the insertion heads glide past one another without colliding, and **in that** the grips (6) are arranged in the region of the sides of the two insertion heads facing toward one another.

2. Device according to Claim 1,
**characterised in that** the grips (6) are arranged in the immediate marginal areas of the insertion heads (4) facing toward one another and **in that** the lateral spacing between the insertion heads is reduced to a narrow safety gap.

3. Method according to Claim 1 or Claim 2,
**characterised in that** the supply devices (11) having pickup positions for the insertion heads (4) of both guide tracks are oriented in the same direction.

4. Device according to Claim 1, 2 or 3,
**characterised in that** the guide tracks (3) are parts of a dual-track closed circular path for the insertion heads (4).

5. Device according to Claim 1,2 or 3,
**characterised in that** the guide tracks (3) are fashioned as end-to-end linear tracks in which the insertion heads (4) can be displaced to and fro over the pickup positions (10) and the substrate carrier (9).

6. Device according to any one of Claims 1 to 5,
**characterised in that** the pickup positions (10) are arranged in a row and **in that** the grips (6) of at least one of the insertion heads (4) can be displaced transversely in relation to the linear track until they are above the pickup positions (10).

7. Device according to Claim 6,
**characterised in that** the pickup positions (10) are arranged in a row between the displacement paths of the insertion heads (4) and **in that** the grips (6) of the two insertion heads (6a) can be displaced until they are above the pickup positions (10).

8. Device according to any one of Claims 1 to 5,
**characterised in that** the supply devices (11) having pickup positions (10) can be displaced transversely in relation to the linear tracks such that the pickup positions (10) alternately pass below the displacement paths of the grips (6) of the two insertion heads (4).

9. Device according to any one of Claims 1 to 5,
**characterised in that** the supply devices (11a) have two rows of pickup positions (10) in the spacing between the two displacement paths of the grips (6).

10. Device according to any one of Claims 1 to 5,
**characterised in that** the pickup positions (1) are distributed on both displacement paths of the grips (6).

11. Device according to Claim 10,
**characterised in that** the pickup positions (10) which are each assigned to one pickup area are distributed in alternating order on the two grip paths.

12. Device according to Claim 10,
**characterised in that** the pickup positions 10 which are each assigned to one pickup area are grouped in blocks.

13. Device according to any one of the preceding Claims,
**characterised in that** a scanning optical system (12) is arranged below the two displacement paths of the grips (6), said scanning optical system covering the grips (6) of both insertion heads (4).

14. Device according to any one of the preceding Claims,
**characterised in that** the separate guide tracks (3) for the two insertion heads (4) are arranged on a common stationary carrier (5) of the device.

15. Device according to Claim 14,
**characterised in that** the guide elements (7) forming guide tracks (3) for the insertion heads (4) are attached on the underside of the carrier (5) on a common mounting base.

16. Device according to any one of the preceding Claims,
**characterised in that** the pickup positions (10) are arranged on both sides of the substrate carrier (9).

17. Device according to Claim 16,
**characterised in that** several of the insertion heads (4) can be displaced independently of one another in at least one of the two guide tracks (3).

18. Device according to any one of the preceding Claims,
**characterised in that** the insertion head (4) has several of the grips (6) arranged consecutively in the direction of displacement.

19. Device according to Claim 18,
**characterised in that** the lateral spacing between the two rows of grips (6) of the two insertion heads (4) is the same as the spacing between two grips (6), arranged consecutively in the direction of displacement, of one of the insertion heads (4).

20. Device according to any one of the preceding Claims,
**characterised in that** stationary driving elements of a linear motor (8) are assigned to the two guide tracks (3) and **in that** the insertion heads (4) are furnished with movable driving elements of the linear motor (8).

21. Device according to any one of the preceding Claims,
**characterised in that** a transport path (1) for the substrates runs parallel to the guide tracks (3) and
**in that** the substrate carrier (9) can be slid transversely in relation to the transport path (1) out from this transport path until it is below the guide tracks of the insertion heads (4).

22. Device according to Claim 21,
**characterised in that** two of the substrate carriers (9) can be slid next to one another out from the transport path (1).

23. Device according to any one of the preceding Claims,
**characterised in that** on the side of the transport path (1) opposite the guide tracks (3) further guide tracks (3), pickup positions (10) for the components and substrate carriers (9) are provided.

24. Device according to any one of the preceding Claims,
**characterised in that** the two insertion heads (4) can respectively be conveyed simultaneously into an insertion position and/or into a pickup position.

25. Method for equipping substrates (2) with electrical components by means of at least two insertion heads (4) which are displaced independently of one another in two stationary guide tracks (3) of the device, said guide tracks being parallel at least in sections, adjacent and running in a defined manner,
wherein the insertion heads (4) with grips (6) for holding the components over at least one row of component pickup positions (10) which is parallel to the guide tracks (3) and over a substrate carrier (9) which can be moved transversely in relation to the guide tracks (3), are displaced, in particular according to one of the preceding Claims,
**characterised in that** the insertion heads (4) of the two guide tracks (3) are guided with such limited lateral displacement that the insertion heads (4) glide past one another without colliding, and **in that** the grips (6) of the two insertion heads (4) are arranged on the sides facing toward one another and
**in that** the insertion heads (4) are respectively conveyed simultaneously into an insertion position and/or into a pickup position.

## Revendications

1. Dispositif pour équiper des substrats (2) avec des composants électriques au moyen d'au moins deux têtes d'insertion (4) qui peuvent être déplacées dans deux glissières de guidage (3) du dispositif voisines fixes, parallèles entre elles du moins par sections et à tracé défini,
les têtes d'insertion (4) déplaçables indépendamment l'une de l'autre étant pourvues de préhenseurs (6) pour tenir les composants,
les têtes d'insertion (4), avec leurs préhenseurs (6), étant déplaçables au-dessus d'au moins une rangée de points d'enlèvement (10) des composants parallèle aux glissières de guidage (3) et les glissières de guidage (3) s'étendant sur au moins un support de substrat (9) déplaçable transversalement par rapport aux glissières de guidage (3),
**caractérisé en ce que** les têtes d'insertion (4) sont guidées dans les deux glissières de guidage (3) avec une distance latérale libre tellement faible que les têtes d'insertion peuvent encore glisser sans collision l'une le long de l'autre et **en ce que** les préhenseurs (6) sont situés dans la zone des côtés des deux têtes d'insertion en regard.

2. Dispositif selon la revendication 1,
**caractérisé en ce que** les préhenseurs (6) sont situés dans les zones marginales des têtes d'insertion (4) immédiates en regard et que la distance latérale entre les têtes d'insertion est réduite à une étroite fente de sécurité.

3. Dispositif selon la revendication 1 ou 2,
**caractérisé en ce que** des dispositifs d'amenée (11) comportant les points d'enlèvement sont orientés dans le même sens pour les têtes d'insertion (4) des deux glissières de guidage.

4. Dispositif selon la revendication 1, 2 ou 3,
**caractérisé en ce que** les glissières de guidage (3) sont des parties d'une trajectoire en boucle fermée à deux pistes pour les têtes d'insertion (4).

5. Dispositif selon la revendication 1, 2 ou 3,
**caractérisé en ce que** les glissières de guidage (3) sont réalisées en tant que guidages linéaires continus dans lesquels les têtes d'insertion (4) sont déplaçables selon un mouvement de va-et-vient au-dessus des points d'enlèvement (10) et du support de substrat (9).

6. Dispositif selon l'une des revendications 1 à 5,
**caractérisé en ce que** les points d'enlèvement (10) sont disposés en une rangée et que les préhenseurs (6) d'au moins l'une des têtes d'insertion (4) sont déplaçables transversalement par rapport au guidage linéaire jusqu'au-dessus des points d'enlèvement (10).

7. Dispositif selon la revendication 6,
**caractérisé en ce que** les points d'enlèvement (10) sont disposés en une rangée située entre les trajectoires de déplacement des têtes d'insertion (4) et **en ce que** les préhenseurs (6) des deux têtes d'insertion (6a) sont déplaçables jusqu'au-dessus des points d'enlèvement (10).

8. Dispositif selon l'une des revendications 1 à 5,
**caractérisé en ce que** des dispositifs d'amenée (11) comportant les points d'enlèvement (10) sont déplaçables transversalement par rapport aux guidages linéaires de manière telle que les points d'enlèvement (10) arrivent en alternance sous les trajectoires de déplacement des préhenseurs (6) des deux têtes d'insertion (4).

9. Dispositif selon l'une des revendications 1 à 5,
**caractérisé en ce que** les dispositifs d'amenée (11a) présentent deux rangées de points d'enlèvement (10) à une distance entre elles équivalant à la distance entre les deux trajectoires de déplacement des préhenseurs (6).

10. Dispositif selon l'une des revendications 1 à 5,
**caractérisé en ce que** les points d'enlèvement (10) sont répartis sur les deux trajectoires de déplacement des préhenseurs (6).

11. Dispositif selon la revendication 10,
**caractérisé en ce que** les points d'enlèvement (10) respectivement affectés à une zone d'enlèvement sont répartis en alignement en alternance sur les deux trajectoires des préhenseurs.

12. Dispositif selon la revendication 10,
**caractérisé en ce que** les points d'enlèvement (10) respectivement affectés à une zone d'enlèvement sont regroupés en blocs.

13. Dispositif selon l'une des revendications précédentes,
**caractérisé en ce qu'**en dessous des deux trajectoires de déplacement des préhenseurs (6) est située une optique de balayage (12) qui couvre les préhenseurs (6) des deux têtes d'insertion (4).

14. Dispositif selon l'une des revendications précédentes,
**caractérisé en ce que** les glissières de guidage (3) séparées pour les deux têtes d'insertion (4) sont situées sur un support (5) fixe commun du dispositif.

15. Dispositif selon la revendication 14,
**caractérisé en ce que** des éléments de guidage (7) pour les têtes d'insertion (4), lesquels forment les glissières de guidage (3), sont placés sur la face inférieure du support (5) sur une base de montage commune.

16. Dispositif selon l'une des revendications précédentes,
**caractérisé en ce que** les points d'enlèvement (10) sont situés de part et d'autre du support de substrat (9).

17. Dispositif selon la revendication 16,
**caractérisé en ce que** plusieurs des têtes d'insertion (4) sont déplaçables indépendamment l'une de l'autre dans au moins l'une des deux glissières de guidage (3).

18. Dispositif selon l'une des revendications précédentes,
**caractérisé en ce que** la tête d'insertion (4) comporte plusieurs des préhenseurs (6) alignés dans la direction du déplacement.

19. Dispositif selon la revendication 18,
**caractérisé en ce que** la distance latérale entre les deux rangées des préhenseurs (6) des deux têtes d'insertion (4) est égale à la distance entre deux préhenseurs (6) de l'une des têtes d'insertion (4) alignés dans la direction du déplacement.

20. Dispositif selon l'une des revendications précédentes,
**caractérisé en ce que** des éléments d'entraînement fixes d'un moteur linéaire (8) sont affectés aux deux glissières de guidage (3) et **en ce que** les têtes d'insertion (4) sont pourvues d'éléments d'entraînement mobiles du moteur linéaire (8).

21. Dispositif selon l'une des revendications précédentes,
**caractérisé en ce qu'**une voie de transport (1) pour les substrats est parallèle aux glissières de guidage (3) et **en ce que** le support de substrat (9) peut être déplacé transversalement par rapport à la voie de transport (1) hors de celle-ci jusque sous les glissières de guidage (3) des têtes d'insertion (4).

22. Dispositif selon la revendication 21,
**caractérisé en ce que** deux des supports de substrat (9) peuvent être déplacés côte à côte hors de la voie de transport (1).

23. Dispositif selon l'une des revendications précédentes,
**caractérisé en ce que** sont prévus, sur le côté de la voie de transport (1) opposé aux glissières de guidage (3), d'autres glissières de guidage (3), points d'enlèvement (10) pour les composants et supports de substrat (9).

24. Dispositif selon l'une des revendications précédentes,
**caractérisé en ce que** les deux têtes d'insertion (4) peuvent être déplacées simultanément vers respectivement une position de pose et/ou vers respectivement une position d'enlèvement.

25. Procédé pour équiper des substrats (2) avec des composants électriques au moyen d'au moins deux têtes d'insertion (4) qui sont déplacées indépendamment l'une de l'autre dans deux glissières de guidage (3) du dispositif voisines fixes, parallèles entre elles du moins par sections et à tracé défini,
les têtes d'insertion (4) avec des préhenseurs (6) pour tenir les composants étant déplacées au-dessus d'au moins une rangée de points d'enlèvement (10) des composants parallèle aux glissières de guidage (3) et au-dessus d'un support de substrat (9) déplaçable transversalement par rapport aux glissières de guidage (3), en particulier selon l'une des revendications précédentes,
**caractérisé en ce que** les têtes d'insertion (4) des deux glissières de guidage (3) sont guidées avec une distance latérale tellement étroite que les têtes d'insertion (4) peuvent encore glisser sans collision l'une le long de l'autre,
**en ce que** les préhenseurs (6) des deux têtes d'insertion (4) sont situés sur les côtés en regard et
**en ce que** les têtes d'insertion (4) sont déplacées simultanément vers respectivement une position de pose et/ou vers respectivement une position d'enlèvement.
